# EUROPEAN PATENT SPECIFICATION

(11) **EP 0 475 361 B1**
(45) Date of publication and mention of the grant of the patent: **01.12.1999**
(21) Application number: 91115296.5
(22) Date of filing: 10.09.1991
(51) Int. Cl.: H01L 27/148

(54) **Image sensor having output unit shielded from capacitively coupled noise originated from the CCD transfer clock signals**
Bildsensor mit Ausgang, welcher vom kapazitiv gekoppelten Rauschen des CCD-Transferclocksignals abgeschirmt ist
Détecteur d'image ayant une unité de sortie protégée contre du bruit que est couplé de façon capacitive et qui provient de signaux de l'horloge de transfert CCD

(30) Priority: 10.09.1990 JP 23948190
(43) Date of publication of application: 18.03.1992
(73) Proprietor: NEC CORPORATION, Tokyo (JP)
(72) Inventor: Miwada, Kazuo, Minato-ku, Tokyo (JP)
(74) Representative: Glawe, Delfs, Moll & Partner

(56) References cited:
- US-A- 4 918 506
- PATENT ABSTRACTS OF JAPAN vol. 9, no. 95 (E-310)24 April 1985 & JP-A-59 221 176 ( TOSHIBA KK )
- * abstract *
- PATENT ABSTRACTS OF JAPAN vol. 5, no. 7 (E-41)17 January 1981 & JP-A-55 138 276 ( NEC CORP )
- * abstract *
- INTERNATIONAL ELECTRON DEVICES MEETING 13 December 1982, SAN FRANCISCO, CA, USA pages 320 - 323; TETSUO YAMADA ET AL.: 'A 3648 ELEMENT CCD LINEAR IMAGE SENSOR'
- JEE JNL OF ELECTRONIC ENGINEERING vol. 17, no. 165, September 1980, TOKYO, JAPAN pages 28 - 31; H. SEKINE ET AL.: 'TOSHIBA'S CCD LINEAR SENSOR: HIGH SENSITIVITY, LOW DARK CURRENT SIGNAL'

## Description

### FIELD OF THE INVENTION

This invention relates to an image sensor and, more particularly, to the structure of an output circuit of the linear image sensor shielded from noises due to transferring clock signal.

### DESCRIPTION OF THE RELATED ART

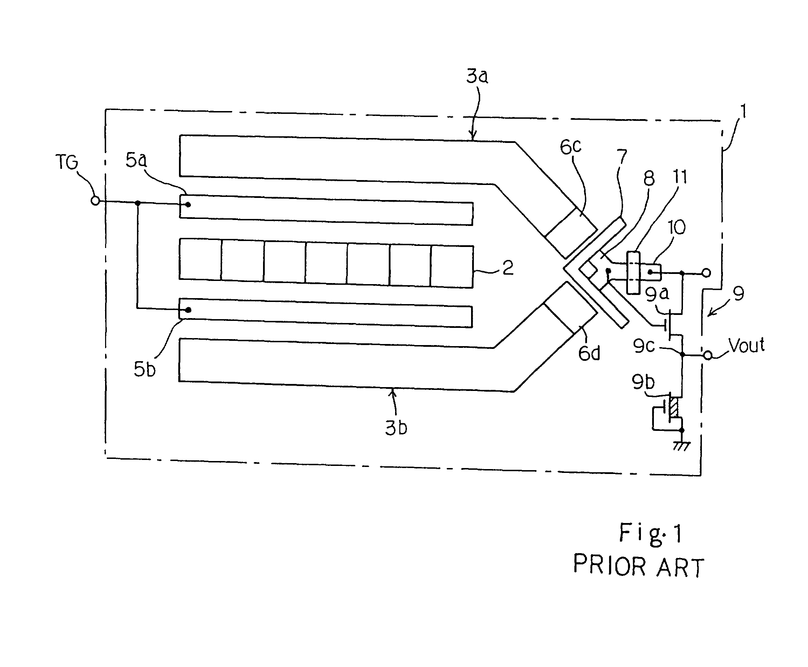

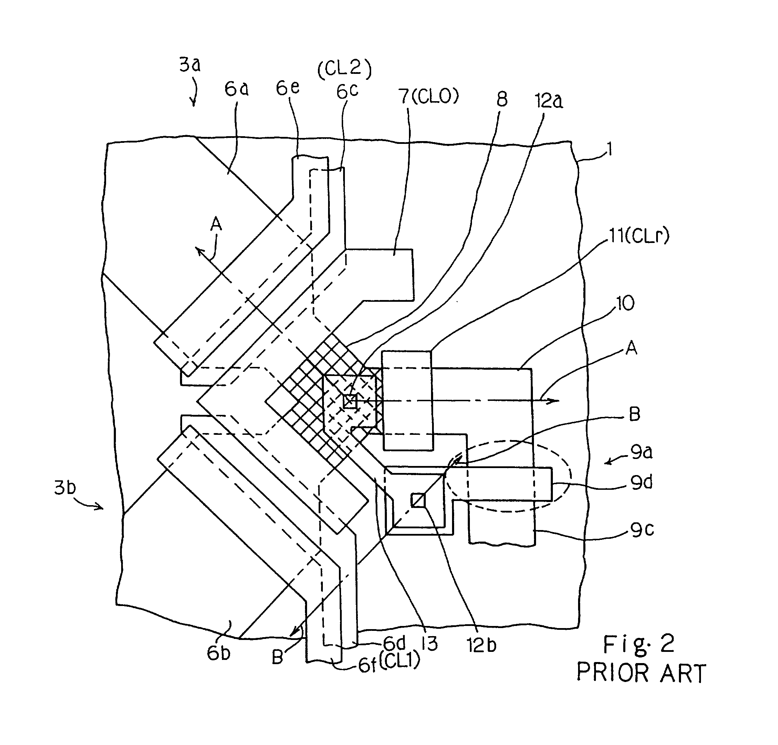

A typical example of the linear image sensor is disclosed in Japanese Patent Application laid-open No. 59-221176, and Figs. 1 to 4 of the drawings illustrate the layout and the structure of the prior art linear image sensor. Referring first to Fig. 1, the prior art linear image sensor is fabricated on a p-type silicon substrate 1, and a line of photoelectric converting elements 2 are formed in the p-type silicon substrate 1. Shift registers 3a and 3b are formed in the p-type silicon substrate 1, and are spaced apart from the photoelectric converting elements 2 by channel regions. The shift registers 3a and 3b are implemented by charge-coupled devices, and comprise n-type impurity regions 6a and 6b (see Fig. 2) in the p-type silicon substrate 1 and charge transferring electrodes provided over the n-type impurity regions 6a and 6b. Transferring electrodes 5a and 5b are provided over the channel regions between the photoelectric converting elements 2 and the n-type impurity regions 6a and 6b of the shift registers 3a and 3b. A read-out signal TG is applied to the transferring electrodes 5a and 5b, and electric charges or charge packets each indicative of the intensity of light fallen upon the photoelectric converting elements 2 are supplied from the photoelectric converting elements 2 to the shift registers 3a and 3b. A multi-phase transferring clock signal consisting of phase 1 clock and phase 2 clock causes the shift registers 3a and 3b to convey the electric charges from stage to stage, and the electric charges sequentially reach the final stages 6c and 6d of the shift registers 3a and 3b. An L-shaped output gate electrode 7 is provided over channel regions between the final stages 6a and 6b and an n-type floating junction region 8 formed in the p-type silicon substrate 1, and the n-type floating junction region 8 is associated with a source-follower circuit 9. The source-follower circuit 9 is implemented by a series combination of an amplifier transistor 9a and a load transistor 9b coupled between an n-type output drain region 10 and a ground line, and the common node 9c is coupled to an output terminal Vout. An output clock signal CLo is applied to the L-shaped output gate electrode 7, and the electric charges alternately flow from the shift registers 3a and 3b to the floating junction region 8. With the electric charges thus flowing thereinto, the voltage level in the floating junction region 8 is varied, and the variation is indicative of the amount of electric charges forming a charge packet and, accordingly, the intensity of light. The n-type floating junction region 8 is coupled with the gate electrode 9d of the amplifier transistor 9a, and the amplifier transistor 9a varies the voltage level at the output terminal Vout depending upon the voltage level in the n-type floating junction region 8. Over that area between the n-type floating junction region 8 and the n-type output drain region 10 is provided a resetting electrode 11 which allows the n-type floating junction region 8 to periodically couple with the n-type output drain region 10 with a reset signal CLr for equalizing the voltage level therebetween.

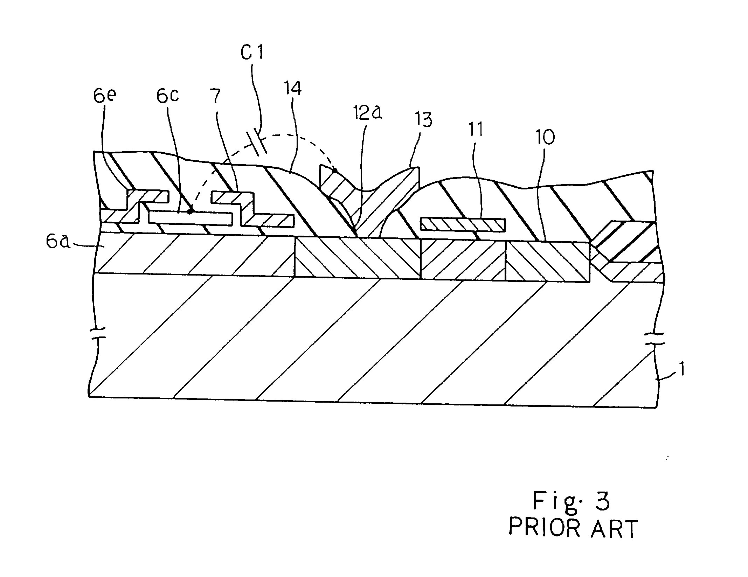

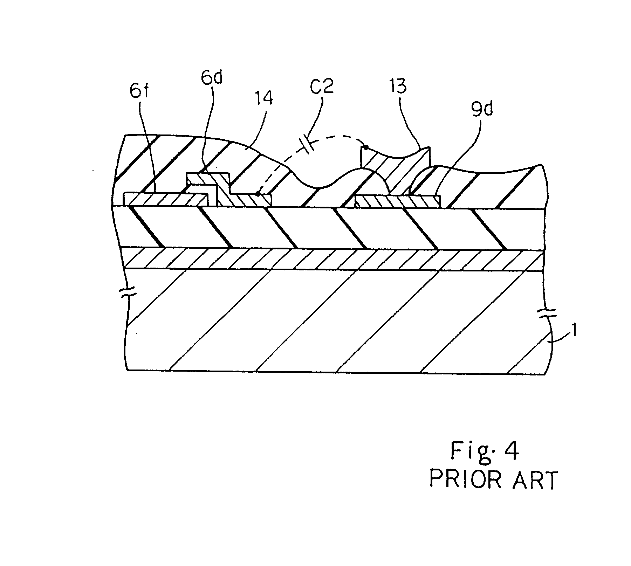

The layout around the n-type floating junction region 8 is illustrated in detail in Fig. 2, and Figs. 3 and 4 illustrate the structure thereof. However, Fig. 2 aims at illustration of arrangement of essential parts provided around the floating junction region 8, and, for this reason, insulating films are deleted from Fig. 2 for better understanding. In Fig. 2, meshes are indicative of the n-type floating junction region 8, and small squares represent contact holes 12a and 12b formed in the insulating film deleted from Fig. 2. The floating junction region 8 is coupled through the contact hole 12a with an interconnection 13 which in turn is coupled through the contact hole 12b with the gate electrode 9d of the amplifier transistor 9a. Over that area between the output drain region 10 and an n-type impurity region or the common node 9c extends the gate electrode 9d which changes the conductance between the output drain region 10 and the common drain node 9c depending upon the voltage level of the floating junction region 8 propagated thereto. The output drain region 10, the gate electrode 9d and the common node 9c as a whole constitute the switching transistor 9a, and the interconnection 13 is faced to the charge transferring electrodes 6c and 6d through a passivation film 14 as will be better understood from Figs. 3 and 4. References 6e and 6f designate other charge transferring gate electrodes slightly overlapped with the transferring gate electrodes 6c and 6d, respectively, and phase 1 clock and phase 2 clock are applied to the transferring gate electrodes 6d/6e and 6c/6f, respectively.

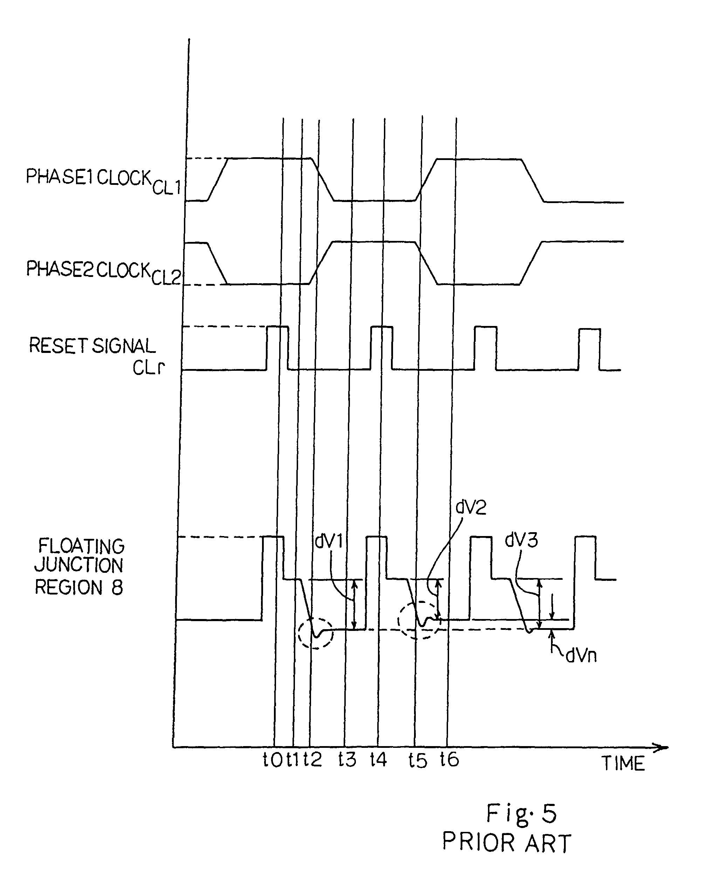

Description is hereinbelow made on the read-out sequence of the linear image sensor with reference to Fig. 5 of the drawings. Assuming now charge packets are read out from the photoelectric converting elements to the shift registers 3a and 3b in the presence of the read-out signal TG periodically applied to the transferring gate electrodes 5a and 5b, the charge packets are conveyed from stage to stage in synchronizing the multi-phase clock signal, and a packet supplied from the shift register 3a has already driven the amplifier transistor 9a before time t0. In the following description, the intensity of light is assumed to be uniform and constant throughout the photoelectric converting operation for better understanding of a problem inherent in the prior art linear image sensor. At time t0, the reset signal CLr is lifted to an active high level, and the output drain region 10 is connected with the floating junction region 8. A potential level due to the charge packet supplied from the shift register 3a is canceled, and voltage level is equalized between the output drain region 10 and the floating junction region 8.

The reset signal CLr is decayed from the active high level at time t1, and the floating junction region 8 enters floating state.

At time t2, phase 1 clock signal is decayed from a high level to a low level, and phase 2 clock signal is lifted from the low level to the high level. The output clock signal CLo follows the phase 1 clock. The charge packet stored in the final stage of the shift register 3b passes through the channel region under the output gate electrode 7 into the floating junction region 8, and the transferring operation is completed by time t3. Then, variation of potential level dV1 takes place in the floating junction region 8 due to the charge packet from the shift register 3b. On the other hand, a new charge packet reaches the final stage of the shift register 3a, and the shift register 3a becomes ready state for the next timing t5. The variation in potential level is reported through the interconnection 13 to the amplifier transistor 9a, and the voltage level at the output terminal Vout is indicative of the intensity of light carried by the charge packet fed from the shift register 3b.

At time t4, the reset clock signal CLr is lifted to the active high level again, and equalizes the voltage level between the output drain region 10 and the floating junction region 8. If phase 1 clock is lifted to the high level and phase 2 clock is decayed to the low level at time t5, the charge packet already stored in the final stage is transferred from the shift register 3a to the floating junction region 8 so that variation dV2 takes place in the floating junction region again at time t6.

Thus, the charge packets are alternately transferred from the shift registers 3a and 3b in synchronization with the multi-phase clock signal, and the amplifier transistor 9a allows the voltage level at the output terminal Vout to trace the intensity of light fallen upon the photoelectric converting elements 2. Variation dV3 is caused by a charge packet fed from the shift register 3b at the next timing assigned thereto.

As described hereinbefore, the intensity of light is uniform and constant, however, the variation dV1 or dV3 is larger than the variation dV2, and a potential difference dVn takes place therebetween. The potential difference dVn is repeated between every even charge packet and every odd charge packet, and deteriorates the signal-to-noise ratio.

The inventor contemplates the problem inherent in the prior art linear image sensor, and finds that difference in parasitic capacitance is causative of the potential difference dVn. Namely, the interconnection 13 faced to the final charge transferring electrode 6c produces a parasitic capacitance C1 (see Fig. 3), and another parasitic capacitance C2 is produced between the interconnection 13 and the final charge transferring electrode 6d (see Fig. 4). It is seldom that parasitic capacitances C1 and C2 are balanced with each other due to dispersion of products. In this situation, after the floating junction region 8 enters the floating state, the voltage level in the floating junction region 8 is affected by phase 1 clock and phase 2 clock. Namely, the voltage level in the floating junction region 6 fluctuates upon lift or recovery of one of phase 2 clock, and the amount of fluctuation is proportional to the parasitic capacitance C1 and the amplitude of phase 2 clock. Phase 1 clock similarly affects the voltage level in the floating junction region 8 upon recovery and lift thereof, and the amount of the fluctuation is also proportional to the parasitic capacitance C2 and the amplitude of phase 1 clock. If the parasitic capacitance C1 is equal to the parasitic capacitance C2 and the amplitude of phase 2 clock is as large as the amplitude of phase 1 clock, the affection through the parasitic capacitance C1 is canceled by the affection through the parasitic capacitance C2, because the phase 1 clock and phase 2 clock are complementary to each other. However, the parasitic capacitance C1 is hardly balanced with the parasitic capacitance C2 as described hereinbefore, and phase 1 clock is not strictly symmetrical with phase 2 clock. This results in the potential difference dVn which deteriorates the signal-to-noise ratio, and elimination of the potential difference dVn is difficult, because the potential difference dVn is produced between every even charge packet and every odd charge packet.

### SUMMARY OF THE INVENTION

It is therefore an important object of the present invention to provide an image sensor which improves the signal-to-noise ratio.

To accomplish the object, the present invention proposes to shield a floating junction region from shift registers . The shielding of a floating junction as part of a CCD element is known from JP-A-55-138276.

In accordance with the present invention, there is provided an image sensor as claimed in claim 1.

### BRIEF DESCRIPTION OF THE DRAWINGS

The features and advantages of the image sensor according to the present invention will be more clearly understood from the following description taken in conjunction with the accompanying drawings in which:
Fig. 1 is a plan view showing the layout of the essential component units of a prior art linear image sensor;
Fig. 2 is a plan view showing, in an enlarged scale, the layout round a floating junction region incorporated in the prior art linear image sensor;
Fig. 3 is a cross sectional view taken along line A-A of Fig. 2 and showing the structure of an output circuit incorporated in the prior art linear image sensor;
Fig. 4 is a cross sectional view taken along line B-B of Fig. 2 and showing the structure of the output circuit at a different angle;
Fig. 5 is a timing chart showing a sequence of a read-out operation carried out in the prior art linear image sensor;
Fig. 6 is a plan view showing the layout of a linear image sensor according to the present invention;
Fig. 7 is a plan view showing, in an enlarged scale, the layout around a floating junction region of the linear image sensor shown in Fig. 6;
Fig. 8 is a cross sectional view taken along line C-C of Fig. 7 and showing the structure of an output circuit incorporated in the liner image sensor; and
Fig. 9 is a cross sectional view taken along line D-D of Fig. 7 and showing the structure of the output circuit at a different angle.

### DESCRIPTION OF THE PREFERRED EMBODIMENT

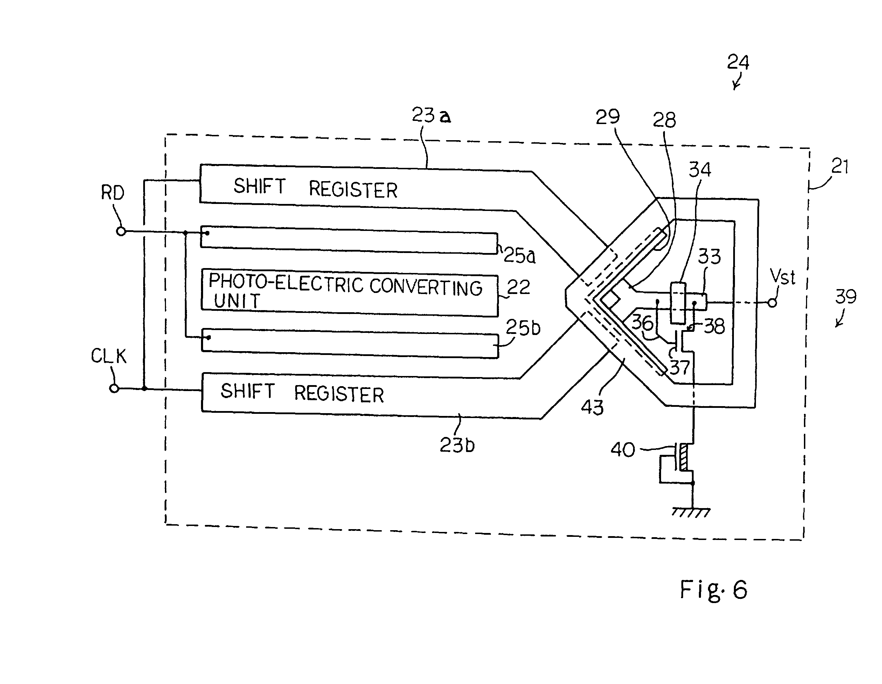

Referring to Fig. 6 of the drawings, a linear image sensor is fabricated on a single p-type silicon substrate 21, and largely comprises a photo-electric converting unit 22, two shift registers 23a and 23b and an output unit 24. The photo-electric converting unit 22 is implemented by a plurality of photo-electric converting elements arranged in a line, and read-out gate electrodes 25a and 25b are provided over channel regions between the photo-electric converting unit 22 and the shift registers 23a and 23b. A read-out timing signal RD is periodically supplied to the read-out gate electrodes 25a and 25b, and the charge packets are read-out from the photo-electric converting unit 22 to the shift registers 23a and 23b.

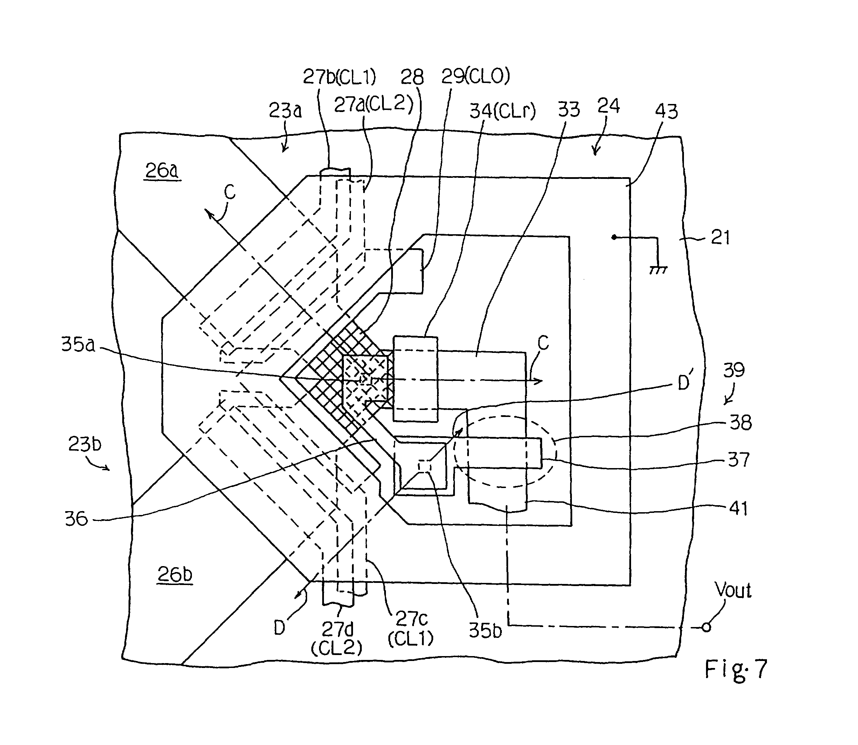

A will be better seen from Fig. 7, the shift registers 23a and 23b respectively have n-type impurity regions 26a and 26b, and a plurality of charge transferring electrodes are provided along the n-type impurity regions 26a and 26b in a slightly overlapped manner. The charge transferring electrodes along the n-type impurity region 26a form a plurality of stages in the n-type impurity region 26a, and references 27a and 27b respectively stand for the charge transferring electrodes associated with the last two stages of the shift register 23a. Similarly, the other charge transferring electrodes form a plurality of stages in the n-type impurity region 26b, and references 27c and 27d respectively designate the charge transferring electrodes associated with the last two stages of the shift register 23b. A multi-phase transferring signal CLK, i.e., a first phase clock CL1 and a second phase clock CL2 complementary to each other, are selectively supplied to the charge transferring electrodes, and the charge transferring electrodes 27c/27b and 27a/27d are supplied with the first and second phase clocks CL1 and CL2.

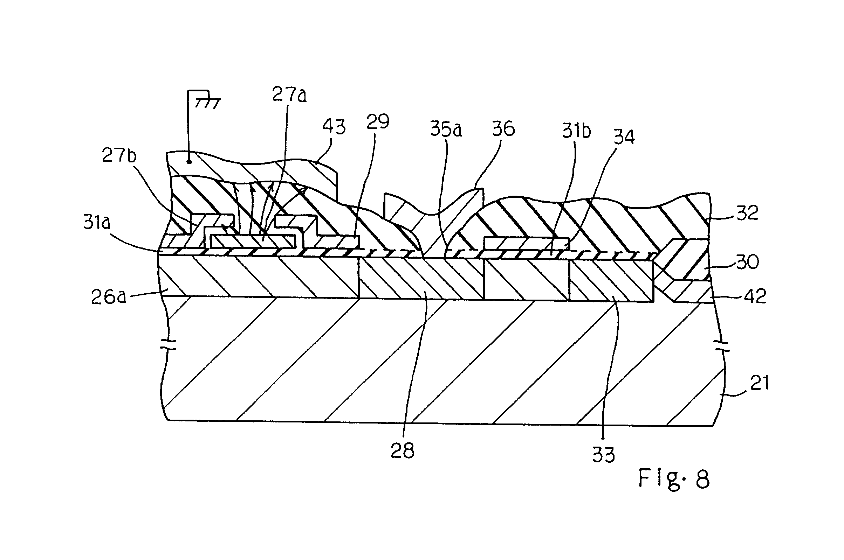

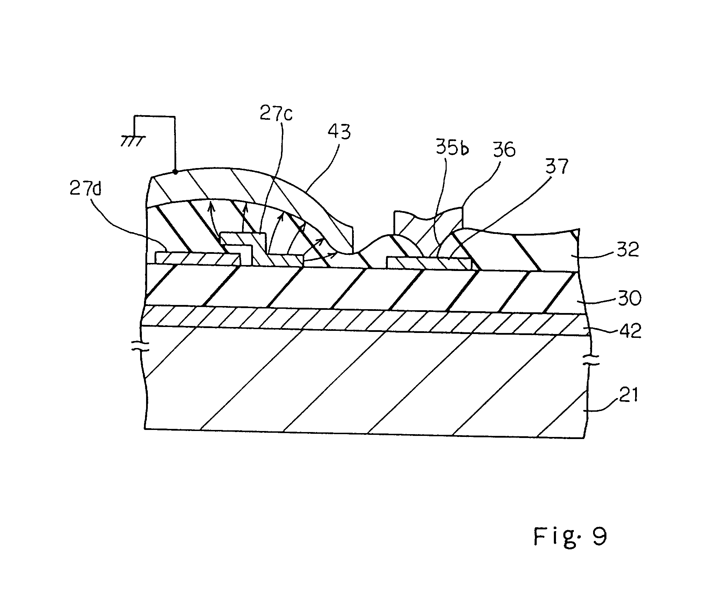

An n-type floating junction region 28 is formed in the p-type silicon substrate 21, and is bifurcated so as to be spaced apart from the n-type impurity regions 26a and 26b by channel forming regions. A generally L-shaped output gate electrode 29 is provided over the channel forming region between the floating junction region 28 and the n-type impurity regions 26a and 26b, and an output clock signal CLo causes the output gate electrode 29 to produce a conductive channel in the channel forming region. Meshes cover the n-type floating junction region 28 for better discrimination from other regions, and insulating films such as a thick field oxide film 30, thin gate oxide films 31a and 31b and an inter-level oxide film 32 are deleted from Fig. 7 for the sake of simplicity. However, those oxide films 30, 31a, 31b and 32 are shown in Figs. 8 and 9.

An output drain region 33 is further formed in the p-type silicon substrate 21, and is spaced from the floating junction region 28 by a channel forming region. A resetting gate electrode 34 is provided over the channel forming region between the floating junction region 28 and the output drain region 33. Since the output drain region 33 is coupled with a source of standard voltage level Vst, a reset clock signal CLr causes the resetting gate electrode 34 to produce a conductive channel in the channel forming region, and substantially equalizes the voltage level therebetween.

Turning to Figs. 8 and 9, contact holes 35a and 35b are formed in the inter-level oxide film 32, and an interconnection 36 of aluminum connects the floating junction region 28 with a gate electrode 37. The gate electrode 37 forms a part of an amplifier transistor 38 which in turn forms an output circuit 39 together with a load transistor 40 as will be better seen from Fig. 6. An n-type impurity region 41 is spaced apart from the output drain region 33 by a channel forming region below the gate electrode 37, and is coupled with an output terminal Vout. The potential variation in the floating junction region 28 is propagated through the interconnection 36 to the gate electrode 37, and channel conductance is varied depending upon the voltage level in the floating junction region 28. For this reason, an output signal takes place at the output terminal Vout, and is indicative of the intensity of optical radiation. In Figs. 8 and 9, reference numeral 42 designates a heavily doped p-type channel stopper formed beneath the thick field oxide film 30.

On the inter-level oxide film 32 is formed a shield electrode 43 which is located over the charge transferring electrodes 27a to 27d. The shield electrode 43 is grounded, and prevents the interconnection 36 and, accordingly, the floating junction region 28 from electric lines of force or electric field around the charge transferring electrodes 27a and 27c. Most of the electric lines of force are taken up by the shield electrode 43. In this instance, the floating junction region 28, the output gate electrode 29, the output drain region 33, the resetting gate electrode 34, the interconnection 36, the output circuit 39 and the shield electrode 43 as a whole constitute the output unit 24.

The linear image sensor implementing the embodiment is similar in operational sequence to the prior art linear image sensor. However, most of the parasitic capacitance C1 and C2 between the interconnection 36 and the charge transferring electrodes 27a and 27c is eliminated from the output unit 24 by virtue of the shield electrode 43, and any potential difference dVn does not take place upon shift of the first and second phase clocks CL1 and CL2. This results in improvement of the signal-to-noise ratio.

Although particular embodiments of the present invention have been shown and described, it will be obvious to those skilled in the art that various changes and modifications may be made without departing from the scope of the present invention. For example, another image sensor may have more than two shift registers, and yet another image sensor may be fabricated on an n-type semiconductor substrate. Moreover, an output unit incorporated in yet another implementation may be not surrounded by a shield electrode, and the shield electrode may be provided over that area between the shift registers and the floating junction region only. Furthermore, the present invention is applicable to an area image sensor.

## Claims

1. An image sensor fabricated on a single semiconductor substrate (21), comprising:
a) a photo-electric converting unit (22) exposed to an optical radiation and producing a plurality of charge packets indicative of an intensity of said optical radiation;
b) shift register means (23a/23b) periodically supplied with said plurality of charge packets, and including
b-1) a first shift register (23a) having a plurality of charge transferring electrodes (27a/27b) for providing a plurality of stages containing a first final transferring stage,
b-2) a second shift register (23b) having a plurality of charge transferring electrodes (27c/27d) for providing a plurality of stages containing a second final transferring stage
said first and second shift registers being responsive to a multi-phase clock signal (CKL) for sequentially transferring said charge packets to said first and second final transferring stages;
c) floating junction region (28) alternately supplied from said first final transferring stage and said second final transferring stage with said charge packets, variation of potential level taking place in said floating junction region when each of said charge packets is supplied thereto,
said floating junction region forming a first parasitic capacitor together with said first final transferring stage and a second parasitic capacitor together with said second final transferring stage;
d) an output drain region (33) periodically connected with said floating junction region for cancelling said variation of potential level; and
e) an output circuit (38) responsive to said variation of potential level for producing an output signal indicative of said intensity of said optical radiation,
**characterized** by
f) a shield means (43) comprising a shield electrode (43) coupled with a constant voltage source and covering said first and second final transferring stages and provided in association with said floating junction region and operative to shield said floating junction region from an electric field due to said multi-phase clock signal applied to said charge transferring electrodes so as to cancel said first parasitic capacitor and said second parasitic capacitor.

2. An image sensor as set forth in claim 1, in which said image sensor further comprises g) an inter-level insulating film ( 32) covering at least said floating junction region, said output drain region and said output circuit, and having contact holes (35a/35b) exposing said floating junction region and a controlling gate electrode of said output circuit, and h) an interconnection (36) formed on said inter-level insulating film and passing through said contact holes so as to couple said floating junction region with said controlling gate electrode, and in which said shield electrode (43) is formed on said inter-level insulating film and extends around said floating junction region, said output drain region, said interconnection and said controlling gate electrode.

## Patentansprüche

1. Bildsensor, der auf einem einzelnen Halbleitersubstrat (21) hergestellt ist, mit:
a) einer photoelektrischen Wandlereinheit (22), die einer optischen Strahlung ausgesetzt ist und eine Mehrzahl von die Intensität der optischen Strahlung anzeigende Ladungspaketen erzeugt;
b) Schieberegistermitteln (23a/23b), die periodisch mit der Mehrzahl der Ladungspaketen versorgt werden und die enthalten:
b-1) ein erstes Schieberegister (23a) mit einer Mehrzahl von Ladungsübertragungselektroden (27a/27b), um eine Mehrzahl von Stufen zu bilden, die eine erste Endübertragungsstufe umfassen;
b-2) einen zweiten Schieberegister (23b) mit einer Mehrzahl von Ladungsübertragungselektroden (27c/27d), um eine Mehrzahl von Stufen zu schaffen, die eine zweite Endübertragungsstufe umfassen;
wobei die ersten und zweiten Schieberegister von einem Mehrphasentaktsignal (CKL) zum sequentiellen Übertragen der Ladungspakete an die erste und zweite Endübertragungsstufe abhängen;
c) einem schwebenden Übergangsgebiet (28), das abwechselnd von der ersten Endübertragungsstufe und der zweiten Endübertragungsstufe mit den Ladungspaketen versorgt wird, wobei eine Änderung des Potentialpegels in dem schwebenden Verbindungsgebiet auftritt, wenn ihm eines der Ladungspakete zugeführt wird;
wobei das schwebende Übergangsgebiet zusammen mit der ersten Endübertragungsstufe einen ersten Störkondensator und zusammen mit der zweiten Endübertragungsstufe einen zweiten Störkondensator bildet;
d) einem Ausgangsdrainbereich (33), der periodisch mit dem schwebenden Übergangsgebiet verbunden wird, um die Änderungen des Potentialpegels auszugleichen; und
e) einer Ausgangsschaltung (38), die von der Änderung des Potentialpegels zur Erzeugung eines Ausgangssignals abhängt, das die Intensität der optischen Strahlung anzeigt;
**gekennzeichnet** durch
f) ein Abschirmmittel (43) mit einer Abschirmelektrode (43), die mit einer Konstantspannungsquelle verbunden ist und die ersten und zweiten Übertragungsstufen abdeckt und im Zusammenhang mit dem schwebenden Übergangsgebiet vorgesehen ist und die zum Abschirmen des schwebenden Übergangsgebiets gegen ein elektrisches Feld betreibbar ist, das auf dem an die Ladungsübertragungselektroden angelegten Mehrphasentaktsignal beruht, um so den ersten Störkondensator und den zweiten Störkondensator zu neutralisieren.

2. Bildsensor nach Anspruch 1, wobei der Bildsensor des weiteren enthält:
g) einen Zwischenpegelisolierfilm (32), der zumindest das schwebende Übergangsgebiet, den Ausgabedrainbereich und die Ausgangsschaltung überdeckt und Kontaktlöcher (35a/35b) hat, die das schwebende Übergangsgebiet und eine Steuergateelektrode der Ausgangsschaltung freilegen, und
h) eine Zwischenverbindung (36), die auf dem Zwischenpegelisolierfilm gebildet ist und durch die Kontaklöcher verläuft, um so das schwebende Übergangsgebiet mit der Steuergateelektrode zu verbinden, und wobei die Abschirmelektrode (43) auf dem Zwischenpegelisolierfilm ausgebildet ist und sich um das schwebende Übergangsgebiet, das Ausgabedraingebiet, die Zwischenverbindung und die Steuergateelektrode herum erstreckt.

## Revendications

1. Capteur d'images fabriqué sur un seul substrat en semi-conducteur (21), et comprenant :
a) une unité de conversion photoélectrique (22), exposée à un rayonnement optique et produisant une pluralité de paquets de charge, indicatifs d'une intensité dudit rayonnement optique ;
b) des moyens formant registres à décalage (23a/23b) recevant périodiquement ladite pluralité de paquets de charges, et comprenant
b-1) un premier registre à décalage (23a) comportant une pluralité d'électrodes de transfert de charges (27a/27b) pour constituer une pluralité d'étages contenant un premier étage final de transfert,
b-2) un deuxième registre à décalage (23b) comportant une pluralité d'électrodes de transfert de charges (27c/27d) pour constituer une pluralité d'étages contenant un deuxième étage final de transfert,
lesdits premier et deuxième registres à décalage réagissant à un signal d'horloge multiphase (CKL) pour transférer, de manière séquentielle, lesdits paquets de charges vers lesdits premier et deuxième étages finaux de transfert ;
c) une zone de jonction flottante (28) recevant lesdits paquets de charge, en alternance à partir dudit premier étage final de transfert et dudit deuxième étage final de transfert, une modification du niveau de potentiel se produisant dans ladite zone de jonction flottante lorsque chacun desdits paquets de charges lui est fourni,
ladite zone de jonction flottante formant un premier condensateur parasite en association avec ledit premier étage final de transfert, et un deuxième condensateur parasite en association avec ledit deuxième étage final de transfert ;
d) une zone de drain de sortie (33) périodiquement reliée à ladite zone de jonction flottante pour annuler ladite modification du niveau de potentiel ; et
e) un circuit de sortie (38), réagissant à ladite modification du niveau de potentiel pour produire un signal de sortie indicatif de ladite intensité dudit rayonnement optique,
caractérisé par
f) un moyen de blindage (43) comprenant une électrode de blindage (43), reliée à une source à tension constante et recouvrant lesdits premier et deuxième étages finaux de transfert et prévue en association avec ladite zone de jonction flottante, et fonctionnant pour protéger ladite zone de jonction flottante contre un champ électrique provoqué par l'application dudit signal d'horloge multiphase auxdites électrodes de transfert de charges, de manière à annuler ledit premier condensateur parasite et ledit deuxième condensateur parasite.

2. Capteur d'images selon la revendication 1, dans lequel ledit capteur d'images comprend en outre :
g) une couche isolante intercouche (32) recouvrant au moins ladite zone de jonction flottante, ladite zone de drain de sortie et ledit circuit de sortie, et comportant des trous de contact (35a/35b) exposant ladite zone de jonction flottante et une électrode de grille de commande dudit circuit de sortie, et
h) une interconnexion (36), formée sur ladite couche isolante intercouche et passant dans lesdits trous de contact de manière à relier ladite zone de jonction flottante à ladite électrode de grille de commande, et dans lequel ladite électrode de blindage (43) est formée sur ladite couche isolante intercouche et s'étend autour de ladite zone de jonction flottante, de ladite zone de drain de sortie, de ladite interconnexion et de ladite électrode de grille de commande.
